# EUROPÄISCHE PATENTSCHRIFT

(11) **EP 3 489 996 B1**
(45) Veröffentlichungstag und Bekanntmachung des Hinweises auf die Patenterteilung: **13.07.2022**
(21) Anmeldenummer: 18213167.2
(22) Anmeldetag: 09.09.2015
(51) Int. Cl.: H01L 23/373, H01L 23/498, H05K 1/03, H05K 3/00

(54) **MEHRLAGENKÜHLER**
MULTI-LAYER COOLER
DISPOSITIF DE REFROIDISSEMENT MULTICOUCHE

(30) Priorität: 09.09.2014 DE 102014217978
(43) Veröffentlichungstag der Anmeldung: 29.05.2019
(62) Teilanmeldung aus: 15762975.9
(73) Patentinhaber: CeramTec GmbH, 73207 Plochingen (DE)
(72) Erfinder: DOHN, Alexander, 96117 Memmelsdorf (DE); DILSCH, Roland, 95199 Thierstein (DE); LENEIS, Roland, 95615 Marktredwitz (DE)

(56) Entgegenhaltungen:
- EP-A2- 1 320 286
- WO-A2-2007/107601
- DE-A1- 10 035 170
- DE-T2- 69 517 248
- JP-A- 2000 058 381
- US-A1- 2002 025 439
- US-A1- 2002 181 185
- US-A1- 2003 218 870

## Beschreibung

Die Erfindung betrifft einen keramischer Trägerkörper mit Kühlelementen und mit versinterten Metallisierungsbereichen.

Luft- oder flüssigkeitsgekühlte keramische Trägerkorper aus Al₂O₃ oder AIN tragen an der Oberflache eine strukturierte Metallisierung (Cu oder Cu-Ni-Au, oder W-Ni-Au) auf die direkt Schaltungsbauteile gelötet werden können. Mit zunehmender Miniaturisierung oder zunehmender Schaltfrequenz bei Leistungsbauteilen können weitere Schaltungselemente wie Abschirmungen, Spulen, Kondensatoren in unmittelbarer Nähe der Bauteile auf der Oberfläche des Trägers notwendig werden. Durch die zwischenzeitlich gestiegenen Schaltfrequenzen wird hochfrequente Störstrahlung erzeugt, welche zur Vermeidung von EMV Problemen aufwändig abgeschirmt werden muss.

WO2007/107601 bezieht sich auf einen Trägerkörper für elektrische oder elektronische Bauelemente oder Schaltungen, wobei der Trägerkörper elektrisch nicht oder nahezu nicht leitend ist.

Der Erfindung liegt daher die Aufgabe zugrunde, einen keramischen Trägerkörper mit Kühlelementen und mit versinterten Metallisierungsbereichen so weiterzubilden, dass mehr Platz für weitere Schaltungselemente (Spulen, Kondensatoren) zur Verfügung steht und/oder die zur Abschirmung der Schaltungen notwendigen zusätzlichen Schaltungselemente untergebracht werden können.

Erfindungsgemäß wird diese Aufgabe durch die in den Ansprüchen 1 und 6 beschriebenen Trägerkörper gelöst.

Der erfindungsgemäße keramische Trägerkörper weist Kühlelemente und versinterte Metallisierungsbereiche auf, die in zumindest zwei Metallisierungsebenen übereinander angeordnet sind, wobei der Trägerkörper eine Oberfläche aufweist, auf der in einer ersten Metallisierungsebene versinterte Metallisierungsbereiche angeordnet sind, die elektronische Bauelemente tragen und/oder so strukturiert sind, dass sie Widerstände oder Spulen bilden und diese Metallisierungsbereiche zusammen mit den Bauelementen und/oder den gebildeten Widerständen oder Spulen von einer keramischen Platte abgedeckt sind und optional auf der keramischen Platte weitere von diesen versinterten Metallisierungsbereichen in weiteren Metallisierungsebenen angeordnet sind und jeweils mit einer keramischen Platte agedeckt sind und auf der obersten, den Kühlelementen abgewandten keramischen Platte versinterte Metallisierunsbereiche in einer Metallisierungsebene zur Aufnahme von Schaltungselementen angeordnet sind.

Um auf dem begrenzten Platz weitere Schaltungselemente (Spulen, Kondensatoren) oder zur Abschirmung der Schaltungen notwendige zusätzliche Schaltungselemente unterbringen zu können, wird somit erfindungsgemäß mindestens eine zusätzliche Metallisierungsebene zwischen Schaltungsebene und Kühlebene (Finnen oder Ebene mit flüssigem Kühlmedium) eingebracht. Diese abgedeckte Metallisierung kann aus dem gleichem Material bestehen, wie die äußere Schaltungsebene, oder auch aus einem anderen, vorzugsweise höher schmelzenden Metall. Ein Kontakt zwischen den metallischen Elementen außen und im Inneren kann durch Vias (gestanzt, lasergebohrt) oder durch bis zum Rand der Keramik herausgezogene und außen verbundene Strukturen hergestellt werden. Diese innere Lage kann zudem strukturiert werden. Sie verbessert das Störverhalten und kann elektronische Bauteile aufnehmen. Durch geeignete Strukturierung und Metallwahl lassen sich Widerstände und Spulen realisieren. Diese innere Lage kann zusammen mit der Deckschicht Kapazitäten ausbilden, die durch die Geometrie und den Abstand bestimmt werden.

Die Kühlelemente sind entweder Finnen am Trägerkörper oder Kühlkanäle im inneren des Trägerkörpers.

Die zusätzliche/n Metallisierungsebene/n trägt/tragen elektronische Bauelemente und/oder sind so strukturiert, dass sie Widerstände oder Spulen bildet/bilden. Die Bauelemente werden dabei so in die Metallisierung eingebaut, dass alles mit einer keramischen Platte abgedeckt werden kann. Wenn die Metallisierung bzw. die Metallisierungsbereiche so strukturiert ist/sind, dass sie Widerstände oder Spulen bildet, bildet die Metallisierung eine Ebene, auf die leicht eine keramische Platte gelegt werden kann.

Der Trägerkörper besteht bevorzugt aus den keramischen Materialien Aluminiumoxid AI203 oder Aluminiumnitrid AlN. Beide Werkstoffe haben eine gute Wärmeleitung und sind elektrisch nicht leitend. Die Metalliesierungsbereiche können mit diesen Materialien leich versintert werden.

Die oberste Metallisierungsebene zur Aufnahme der Schaltungselemente besteht bevorzugt aus Kupfer und die inneren Metallisierungsebenen aus Wolfram.

Ein nicht beanspruchtes Verfahren zur Herstellung eines erfindungsgemäßen Trägerkörpers beinhaltet, dass zur Herstellung einer Metallisierungsebene nach der Herstellung des keramischen Trägerkörpers mit den Kühlelementen
a) Teilbereiche der Oberfläche des Trägerkörpers mit einer Wolfram-Glas-Paste im Siebdruck beschichtet werden, wobei an zumindest einer Stelle die Wolfram-Glas-Paste bis an die Außenkante des Trägerkörpers gedruckt wird,
b) anschließend die nicht beschichteten Flächen mit einer Isolierpaste bedruckt werden, danach die Wolfram-Glas-Paste und die Isolierpaste entbindert werden,
c) anschließend eine geschliffene keramische Platte auf die entbinderten Pasten gelegt wird
d) und dann optional die Verfahrensschritte a, b und c wiederholt werden, wobei dann die keramische Platte bedruckt wird und
e) zum Schluss zur Schaffung von Seiten-Metallisierungenen mit einem weiteren Siebdruckschritt mit Kupferpaste auf die Seitenfläche des Trägerkörpers die inneren Wolfram Metallisierungen mit der obersten Kupfer Metallisierung verbunden werden.

Die einzelnen Verfahrensschritte sind allgemein bekannt. Anstatt oder zusätzlich zu den Seiten-Metallisierungenen zwischen den Metallisierungsebenen können auch VIAS zur elektrischen Verbindung der inneren Wolfram Metallisierungen mit der obersten Kupfer Metallisierung eingebracht werden.

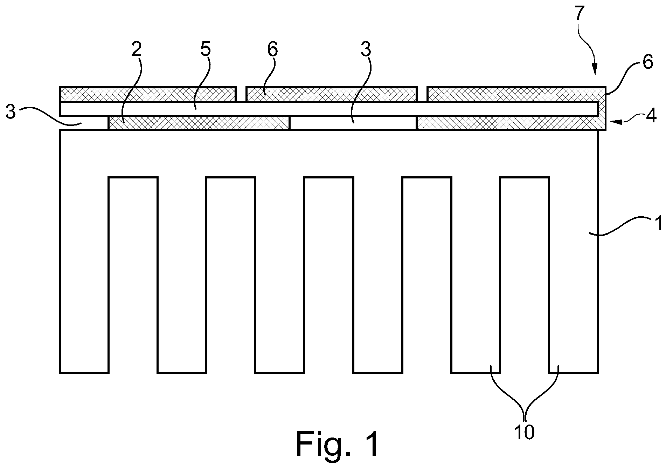

Beispiel:
Ein geschliffener Kühlkörper 1 mit Finnen 10 (siehe Figur 1) aus AIN mit einer Größe von 40*40*30 mm wird auf der Oberfläche mit einer Wolfram-Glas-Paste 2 im Siebdruck in Kondensatorform 15 µm hoch beschichtet. Mit einem hierzu komplementären Sieb wird mit einer Isolierpaste 3 die restliche Fläche bedruckt (enthält ein Glas oder die gleiche Keramik, aus der auch der Kühlkörper 1 besteht). Die Wolfram-Glas-Paste 2 wird an einer Stelle 4 bis an die Außenkante des Kühlkörpers 1 gedruckt.

Die Wolfram-Glas-Paste 2 und die Isolierpaste 3 werden bei 500°C entbindert. Eine geschliffene keramische Platte 5 aus AIN mit einer Abmessung von 40*40*2 mm wird auf den Kühlkörper 1, bzw. auf die entbinderte Wolfram-Glas-Paste 2 und die Isolierpaste 3 aufgelegt und mit dem bedruckten Kühlkörper 1 bei 1300°C in feuchtem Stickstoff-Wasserstoff aufgebrannt. Dabei verbinden sich die beiden keramischen Teile, d.h. der Kühlkörper 1 mit seinen Finnen 10 und die keramische Platte 5. Die gebrannte Wolfram-Glas-Paste 2 bildet dann eine Zwischenschicht bzw. eine Metallisierung aus Wolfram. Diese Zwischenschicht wird auch als Metallisierungsbereich genannt und bildet eine Metallisierungsebene.

Auf die Oberseite der Platte 5 aus AIN wird mit Kupferpaste 6 ein Motiv bzw. eine Metallisierung gedruckt. Die Schichtdicke der Kupferpaste 6 liegt vorzugsweise zwischen 15 und 300 µm. Der Kupferdruck bzw. die Kupferpaste 6 reicht bis an die Außenkante 7 der Platte 5 und wird mit einem weiteren Siebdruckschritt mit Kupferpaste 6 auf die Seitenfläche mit dem Wolfram der Zwischenschicht verbunden.

Bei 910°C wird in Stickstoff die Kupferpaste 6 bzw. die Kupfermetallisierung eingebrannt.

Die Erfindung beschreibt somit einen keramischen Trägerkörper mit Kühlelementen und einer Schaltungsebene, die aus versinterten Metallisierungsbereichen zur Aufnahme von Schaltungselementen besteht, wobei zwischen der Schaltungsebene und dem Trägerkörper zumindest eine zusätzliche Metallisierungsebene mit versinterten Metallisierungen angeordnet ist, wobei jede dieser zusätzlichen Metallisierungen von einer keramischen Platte abgedeckt ist und die Metallisierungen der Schaltungsebene mit der obersten, den Kühlelementen abgewandten keramischen Platte versintert sind und die versinterten Metallisierungen der Metallisierungsebenen mit den Metallisierungen der Schaltungsebene über Vias oder durch bis zum Rand der Keramik herausgezogene und außen verbundene elektrisch leitende Strukturen miteinander verbunden ist/sind.

## Patentansprüche

1. Keramischer Trägerkörper (1) mit Kühlelementen und mit versinterten Metallisierungsbereichen, die in zumindest zwei Metallisierungsebenen übereinander angeordnet sind, wobei der Trägerkörper (1) eine Oberfläche aufweist, auf der in einer ersten Metallisierungsebene versinterte Metallisierungsbereiche angeordnet sind, diese Metallisierungsbereiche von einer keramischen Platte (5) abgedeckt sind und auf der keramischen Platte versinterte Metallisierunsbereiche in einer obersten Metallisierungsebene zur Aufnahme von Schaltungselementen angeordnet sind und Metallisierungsebenen aus Wolfram bestehen, wobei die in der ersten Metallisierungsebene versinterten Metallisierungsbereiche so strukturiert sind, dass sie Widerstände oder Spulen bilden und diese Metallisierungsbereiche zusammen mit den gebildeten Widerständen oder Spulen von der keramischen Platte (5) abgedeckt sind und optional auf der keramischen Platte weitere von diesen versinterten Metallisierungsbereichen in weiteren Metallisierungsebenen angeordnet sind und jeweils mit einer keramischen Platte abgedeckt sind und auf der obersten, den Kühlelementen abgewandten keramischen Platte (5) die versinterten Metallisierunsbereiche in einer obersten Metallisierungsebene zur Aufnahme von Schaltungselementen angeordnet sind und die inneren Metallisierungsebenen aus Wolfram bestehen, **dadurch gekennzeichnet, dass** die oberste Metallisierungsebene zur Aufnahme der Schaltungselemente aus Kupfer besteht und dass auf der Seitenfläche des Trägerkörpers Seiten-Metallisierungen aus Kupfer angeordnet sind, welche die inneren Wolfram Metallisierungsebenen mit der obersten Kupfer Metallisierungsebene verbinden.

2. Trägerkörper (1) nach Anspruch 1, **dadurch gekennzeichnet, dass** die Kühlelemente Finnen (10) am Trägerkörper (1) oder Kühlkanäle im inneren des Trägerkörpers (1) sind.

3. Trägerkörper (1) nach Anspruch 1 oder 2, **dadurch gekennzeichnet, dass** die weitere/n Metallisierungsebene/n so strukturiert ist/sind, dass sie Widerstände oder Spulen bildet/bilden.

4. Trägerkörper (1) nach einem der Ansprüche 1 bis 3, **dadurch gekennzeichnet, dass** der Trägerkörper (1) aus den keramischen Materialien Aluminiumoxid Al2O3 oder Aluminiumnitrid ALN besteht.

5. Trägerkörper (1) nach einem der Ansprüche 1 bis 4, **dadurch gekennzeichnet, dass** zwischen den Metallisierungsebenen VIAS zur elektrischen Verbindung der inneren Wolfram Metallisierungsebenen mit der obersten Kupfer Metallisierungsebene eingebracht sind.

6. Keramischer Trägerkörper (1) mit Kühlelementen und mit versinterten Metallisierungsbereichen auf den Kühlelementen und mit einer inneren Metallisierungsebene mit versinterten Metallisierungsbereichen auf dem Kühlelement, wobei die innere Metallisierungsebene so strukturiert ist, dass sie Widerstände oder Spulen bildet, mit einer obersten Metallisierungsebene mit versinterten Metallisierungsbereichen, einer keramischen Platte (5) zwischen der inneren Metallisierungsebene und der obersten Metallisierungsebene und die innere Metallisierungsebene aus Wolfram besteht, **dadurch gekennzeichnet, dass** die oberste Metallisierungsebene aus Kupfer besteht und auf der Seitenfläche des Trägerkörpers Seiten-Metallisierungen angeordnet sind, welche die innere/n Wolfram Metallisierungsebene/n mit der obersten Metallisierungsebene elektrisch verbinden.

7. Trägerkörper (1) nach Anspruch 6, **dadurch gekennzeichnet, dass** auf der obersten Metallisierungsebene Schaltungselemente angeordnet sind.

8. Trägerkörper (1) nach Anspruch 6 oder 7, **dadurch gekennzeichnet, dass** die Kühlelemente Finnen (10) am Trägerkörper (1) oder Kühlkanäle im inneren des Trägerkörpers (1) sind.

9. Trägerkörper (1) nach einem der Ansprüche 6 bis 8, **dadurch gekennzeichnet, dass** eine oder mehrere weitere innere Metallisierungsebenen mit versinterten Metallisierungsbereichen und eine oder mehrere weitere keramische Platten (5) vorgesehen sind, wobei die keramischen Platten (5) zwischen den inneren Metallisierungsebenen angeordnet sind.

10. Trägerkörper (1) nach Anspruch 9, **dadurch gekennzeichnet, dass** zumindest eine der weiteren inneren Metallisierungsebenen mit den versinterten Metallisierungsbereichen so strukturiert ist, dass sie Widerstände oder Spulen bildet.

11. Trägerkörper (1) nach einem der Ansprüche 6 bis 10, **dadurch gekennzeichnet, dass** der Trägerkörper (1) aus den keramischen Materialien Aluminiumoxid Al2O3 oder Aluminiumnitrid AlN besteht.

12. Trägerkörper (1) nach einem der Ansprüche 6 bis 11, **dadurch gekennzeichnet, dass** zwischen der/n inneren Wolfram Metallisierungsebene/n VIAS angeordnet sind.

## Claims

1. Ceramic carrier body (1) comprising cooling elements and sintered metallization regions which are arranged one above the other in at least two metallization planes, the carrier body (1) having a surface on which sintered metallization regions are arranged in a first metallization plane, these metallization regions being covered by a ceramic plate (5) and, on the ceramic plate, sintered metallization regions being arranged in a top metallization plane for receiving circuit elements and metallization planes being made of tungsten, the metallization regions sintered in the first metallization plane being structured in such a way that they form resistors or coils and these metallization regions together with the formed resistors or coils being covered by the ceramic plate (5) and, optionally on the ceramic plate, more of these sintered metallization regions being arranged in further metallization planes and each being covered by a ceramic plate and, on the top ceramic plate (5) facing away from the cooling elements, the sintered metallization regions being arranged in a top metallization plane for receiving circuit elements and the inner metallization planes being made of tungsten, **characterized in that** the top metallization plane for receiving the circuit elements is made of copper and **in that** lateral metallizations made of copper are arranged on the lateral face of the carrier body, which metallizations connect the inner tungsten metallization planes to the top copper metallization plane.

2. Carrier body (1) according to claim 1, **characterized in that** the cooling elements are fins (10) on the carrier body (1) or cooling channels in the interior of the carrier body (1).

3. Carrier body (1) according to either claim 1 or claim 2, **characterized in that** the further metallization plane(s) is/are structured in such a way it/they form(s) resistors or coils.

4. Carrier body (1) according to any of claims 1 to 3, **characterized in that** the carrier body (1) is made of the ceramic materials aluminum oxide Al2O3 or aluminum nitride AIN.

5. Carrier body (1) according to any of claims 1 to 4, **characterized in that** VIAs are introduced between the metallization planes for electrically connecting the inner tungsten metallization planes to the top copper metallization plane.

6. Ceramic carrier body (1) comprising cooling elements and sintered metallization regions on the cooling elements and comprising an inner metallization plane having sintered metallization regions on the cooling element, the inner metallization plane being structured in such a way that it forms resistors or coils, comprising a top metallization plane having sintered metallization regions, a ceramic plate (5) between the inner metallization plane and the top metallization plane and the inner metallization plane being made of tungsten, **characterized in that** the top metallization plane is made of copper and lateral metallizations are arranged on the lateral face of the carrier body, which metallizations electrically connect the inner tungsten metallization plane(s) to the top metallization plane.

7. Carrier body (1) according to claim 6, **characterized in that** circuit elements are arranged on the top metallization plane.

8. Carrier body (1) according to either claim 6 or claim 7, **characterized in that** the cooling elements are fins (10) on the carrier body (1) or cooling channels in the interior of the carrier body (1).

9. Carrier body (1) according to any of claims 6 to 8, **characterized in that** one or more further inner metallization planes having sintered metallization regions and one or more further ceramic plates (5) are provided, the ceramic plates (5) being arranged between the inner metallization planes.

10. Carrier body (1) according to claim 9, **characterized in that** at least one of the further inner metallization planes having the sintered metallization regions is structured in such a way that it forms resistors or coils.

11. Carrier body (1) according to any of claims 6 to 10, **characterized in that** the carrier body (1) is made of the ceramic materials aluminum oxide Al2O3 or aluminum nitride AIN.

12. Carrier body (1) according to any of claims 6 to 11, **characterized in that** VIAs are arranged between the inner tungsten metallization plane(s).

## Revendications

1. Corps de support (1) en céramique comportant des éléments de refroidissement et comportant des zones de métallisation frittées qui sont disposées les unes au-dessus des autres dans au moins deux niveaux de métallisation, le corps de support (1) présentant une surface sur laquelle des zones de métallisation frittées sont disposées dans un premier niveau de métallisation, lesdites zones de métallisation étant recouvertes par une plaque en céramique (5e) et des zones de métallisation frittées étant disposées sur la plaque en céramique dans un niveau de métallisation le plus élevé pour recevoir des éléments de circuit, et des niveaux de métallisation étant constitués de tungstène, les zones de métallisation frittées dans le premier niveau de métallisation étant structurées de telle manière qu'elles forment des résistances ou des bobines et lesdites zones de métallisation, conjointement avec les résistances ou les bobines formées, étant recouvertes par la plaque en céramique (5) et éventuellement plusieurs desdites zones de métallisation frittées étant disposées sur la plaque en céramique dans un niveau de métallisation supplémentaire et étant respectivement recouvertes par une plaque en céramique, et les zones de métallisation frittées étant disposées sur la plaque en céramique (5) la plus élevée opposée aux éléments de refroidissement, dans un niveau de métallisation le plus élevé, pour recevoir des éléments de circuit, et les niveaux de métallisation internes étant constitués de tungstène, **caractérisé en ce que** le niveau de métallisation le plus élevé permettant de recevoir les éléments de circuit est constitué de cuivre et **en ce que** des métallisations latérales en cuivre, lesquelles relient les niveaux de métallisation internes en tungstène au niveau de métallisation le plus élevé en cuivre, sont disposées sur la surface latérale du corps de support.

2. Corps de support (1) selon la revendication 1, **caractérisé en ce que** les éléments de refroidissement sont des ailettes (10) sur le corps de support (1) ou des canaux de refroidissement à l'intérieur du corps de support (1).

3. Corps de support (1) selon la revendication 1 ou 2, **caractérisé en ce que** les niveaux de métallisation supplémentaires sont structurés de telle manière qu'ils forment des résistances ou des bobines.

4. Corps de support (1) selon l'une des revendications 1 à 3, **caractérisé en ce que** le corps de support (1) est constitué des matériaux céramiques oxyde d'aluminium Al2O3 ou nitrure d'aluminium AIN.

5. Corps de support (1) selon l'une des revendications 1 à 4, **caractérisé en ce que** des vias sont introduits entre les niveaux de métallisation pour la connexion électrique des niveaux de métallisation internes en tungstène au niveau de métallisation le plus élevé en cuivre.

6. Corps de support en céramique (1) comportant des éléments de refroidissement et comportant des zones de métallisation frittées sur les éléments de refroidissement et comportant un niveau de métallisation interne comportant des zones de métallisation frittées sur l'élément de refroidissement, le niveau de métallisation interne étant structuré de telle manière qu'il forme des résistances ou des bobines, comportant un niveau de métallisation le plus élevé comportant des zones de métallisation frittées, une plaque en céramique (5) entre le niveau de métallisation interne et le niveau de métallisation le plus élevé, et le niveau de métallisation interne étant constitué de tungstène, **caractérisé en ce que** le niveau de métallisation le plus élevé est constitué de cuivre et des métallisations latérales, lesquelles relient électriquement les niveaux de métallisation internes en tungstène au niveau de métallisation le plus élevé, sont disposées sur la surface latérale du corps de support.

7. Corps de support (1) selon la revendication 6, **caractérisé en ce que** des éléments de circuit sont disposés sur le niveau de métallisation le plus élevé.

8. Corps de support (1) selon la revendication 6 ou 7, **caractérisé en ce que** les éléments de refroidissement sont des ailettes (10) sur le corps de support (1) ou des canaux de refroidissement à l'intérieur du corps de support (1).

9. Corps de support (1) selon l'une des revendications 6 à 8, **caractérisé en ce qu'**un ou plusieurs niveaux de métallisation internes supplémentaires comportant des zones de métallisation frittées et une ou plusieurs plaques en céramique (5) supplémentaires sont prévus, les plaques en céramique (5) étant disposées entre les niveaux de métallisation internes.

10. Corps de support (1) selon la revendication 9, **caractérisé en ce qu'**au moins l'un des niveaux de métallisation internes supplémentaires comportant les zones de métallisation frittées est structuré de telle manière qu'il forme des résistances ou des bobines.

11. Corps de support (1) selon l'une des revendications 6 à 10, **caractérisé en ce que** le corps de support (1) est constitué des matériaux céramiques oxyde d'aluminium Al2O3 ou nitrure d'aluminium AIN.

12. Corps de support (1) selon l'une des revendications 6 à 11, **caractérisé en ce que** des vias sont disposés entre les niveaux de métallisation internes en tungstène.
